# EUROPEAN PATENT APPLICATION

(11) **EP 2 063 460 A1**
(43) Date of publication of application: **27.05.2009**
(21) Application number: 06797847.8
(22) Date of filing: 12.09.2006
(51) Int. Cl.: H01L 21/301, H01L 21/52

(54) **DICING/DIE BONDING FILM**

(71) Applicant: Nitto Denko Corporation, Ibaraki-shi, Osaka 567-8680 (JP)
(72) Inventor: MATSUMURA, Takeshi, Ibaraki-shi Osaka 567-8680 (JP); MISUMI, Sadahito, Ibaraki-shi Osaka 567-8680 (JP)
(74) Representative: Sajda, Wolf E.
(86) International application number: PCT/JP2006/318055
(87) International publication number: WO 2008/032367

(57) **Abstract**

The invention relates to a dicing die-bonding film having a pressure-sensitive adhesive layer and a die bonding adhesive layer being sequentially laminated on a supporting substrate, wherein the pressure-sensitive adhesive layer has a thickness of 10 µm to 80 µm, and has a storage elastic modulus at 23 °C of 1 x 10⁴ to 1 x 10¹⁰ Pa.

## Description

### TECHNICAL FIELD

The present invention relates to a dicing die-bonding film. The dicing die-bonding film is used to provide a workpiece for dicing in a state where an adhesive to fix a chip-shaped workpiece (such as a semiconductor chip) and an electrode member is attached to the workpiece (such as a semiconductor wafer) before dicing. Further, the present invention relates to a method of fixing a chip-shaped workpiece and a method of manufacturing a semiconductor device using the dicing die-bonding film. Furthermore, it relates to a semiconductor device in which a chip-shaped workpiece is adhered and fixed with the fixing method and the manufacturing method.

### BACKGROUND ART

In conventional manufacturing of a semiconductor device, a silver paste has been used in fixing a semiconductor chip onto a lead frame and an electrode member. Such fixing process has been performed by coating the paste onto a die pad of the lead frame, etc., loading the semiconductor chip onto this, and curing the paste layer.

A semiconductor wafer in which a circuit pattern is formed is diced into semiconductor chips (a dicing step) after the thickness is adjusted by backside polishing if necessary (a back grinding step), this semiconductor chip is fixed onto an adherend such as a lead frame with an adhesive (a die attaching step), and a wire bonding step is further performed. In the dicing step, the semiconductor wafer is normally washed with moderate hydraulic pressure in order to remove cutting scraps.

In this process step, with a method of coating an adhesive separately onto the lead frame and a forming chip, it is difficult to make the adhesive layer uniform, and a special apparatus and a long time become necessary in coating of the adhesive. For this reason, in the following Patent Document 1, a dicing die-bonding film is proposed that adheres and holds the semiconductor wafer in the dicing step and also gives an adhesive layer for fixing a chip which is necessary in the die attaching step.

This dicing die-bonding film is formed by providing a peelable adhesive layer onto a supporting substrate, dicing is performed on the semiconductor wafer while being held by the adhesive layer, the forming chips are then peeled with the adhesive layer by stretching the supporting substrate, and these are individually collected and fixed onto an adherend such as a lead frame interposing the adhesive layer therebetween.

Here, a strong adhesive strength is required in the dicing die-bonding film so that the supporting substrate and the adhesive layer are not peeled during dicing of the semiconductor wafer, and on the other hand, the semiconductor chip is required to be easily peeled together with the adhesive layer from the supporting substrate after dicing.

However, it is difficult to adjust the adhesive strength of the adhesive layer if the dicing die-bonding film has the above constitution. For this reason, a dicing die-bonding film is disclosed that is configured so that the balance between adherability and peeling properties becomes good by providing a pressure-sensitive adhesive layer between the supporting substrate and the adhesive layer (see the following Patent Document 2).

Incidentally, in the dicing step, yarn-shaped scraps are generated from the dicing die-bonding film when cutting the semiconductor wafer in which a circuit pattern is formed, and may be attached onto the semiconductor chip and the dicing die-bonding film. Furthermore, these yarn-shaped scraps not only remarkably decrease workability by attaching onto an organic substrate, a lead frame, or the semiconductor chip which is an adherend in the die attaching step and the wire bonding step which are the next steps, but also decreases reliability of the semiconductor chip, and have become a large problem.

| | |
|---|---|
| Patent Document 1: | Japanese Patent Application Laid-Open JP-A-60-057 642 (a first page) |
| Patent Document 2 : | JP-A-2-248 064 (a first page) |

### DISCLOSURE OF THE INVENTION

### PROBLEMS TO BE SOLVED BY THE INVENTION

The present invention is performed in view of the above problems, and its objective is to provide a dicing die-bonding film in which generation of yarn-shaped scraps is suppressed and a decrease of the grade of a semiconductor chip is prevented, a method of fixing a chip-shaped workpiece using the same, a semiconductor device obtained by the method, and a manufacturing method thereof.

### MEANS FOR SOLVING THE PROBLEMS

As a result of investigation in order to achieve the above objective, the present inventors have found that the generation of yarn-shaped scraps is caused by cutting of a supporting substrate with the dicing blade, and came to complete the present invention by adopting the following constitution.

That is, the present invention relates to a dicing die-bonding film comprising a pressure-sensitive adhesive layer and a die bonding adhesive layer being sequentially laminated on a supporting substrate, wherein the pressure-sensitive adhesive layer has a thickness of 10 to 80 µm, and has a storage elastic modulus at 23 °C of 1 x 10⁴ to 1 x 10¹⁰ Pa.

The invention of the above constitution is to set the elastic component (that is, hardness) of the pressure-sensitive adhesive layer in a prescribed range by making the thickness of the pressure-sensitive adhesive layer 10 to 80 µm and the storage elastic modulus of the pressure-sensitive adhesive layer at 23°C in the range of 1 x 10⁴ to 1 x 10¹⁰ Pa. That is, by making them in the above numerical value range, the cut depth during dicing is stopped at the pressure-sensitive adhesive layer and the supporting substrate is prevented from being diced. As a result, the generation of yarn-shaped scraps can be prevented.
When the storage elastic modulus is less than 1 x 10⁴ Pa, the workpiece may be moved by vibration when the workpiece is diced for example. However, by making them in the above numerical value range, it is suppressed, and as a result, a damage of a Part of the workpiece that is made into chips, so-called chipping, can be reduced. Furthermore, when the storage elastic modulus exceeds 1 x 10¹⁰ Pa, the adhesive strength of the pressure-sensitive adhesive layer to the die bonding adhesive layer sometimes becomes insufficient. However, by making them in the above numerical value range, an excessive reduction of the adhesive strength is suppressed, and as a result, the workpiece is certainly fixed onto the dicing die-bonding film and the generation of chip fly or positional shift during dicing can be suppressed.

It is also preferable that the pressure-sensitive adhesive layer is a radiation curing type pressure-sensitive adhesive layer.

It is also preferable that the numerical value range of the storage elastic modulus in the pressure-sensitive adhesive layer is satisfied at least by a portion corresponding to a workpiece attachment portion of the die bonding adhesive layer.

It is also preferable that the peeling properties at the interface between the pressure-sensitive adhesive layer and the die bonding adhesive layer, which is the interface corresponding to the workpiece attachment portion are greater than the peeling properties at the interface corresponding to a portion or the entirety other than the workpiece attachment portion.

The relationship of peeling properties of the above interface can be obtained by making a constitution in which the adhesive strength of the above pressure-sensitive adhesive layer to the die bonding adhesive layer, which is the adhesive strength of the portion corresponding to the workpiece attachment portion is smaller than the adhesive strength of the portion corresponding to a portion or the entirety other than the workpiece attachment portion.

By making the above constitution, in the portion corresponding to a portion or the entirety other than the workpiece attachment portion, comparing with the portion corresponding to the workpiece attachment portion, the pressure-sensitive adhesive layer and the die bonding adhesive layer are made to be in a state of being moderately adhered. As a result, the pressure-sensitive adhesive layer and the die bonding adhesive layer can be made so as not to be easily peeled even when dicing and expanding for example.
On the other hand, in the portion corresponding to the workpiece attachment portion, light peeling off is made to be possible compared with the other portion. For this reason, a chip-shaped workpiece which is obtained after dicing can be easily peeled without leading to a poor dicing even from a large-sized chip such as exceeding 10 mm x 10 mm for example, and a dicing die-bonding film having excellent pick-up properties can be obtained. That is, with the above constitution, the holding force during dicing, etc. and the peeling properties during pick-up are moderately balanced.

It is also preferable that the adhesive strength of the die bonding adhesive layer to the workpiece at the workpiece attachment portion is greater than the adhesive strength to the pressure-sensitive adhesive layer at the portion corresponding to the workpiece attachment portion.

By making the above constitution, when picking-up a chip-shaped workpiece obtained by dicing the workpiece for example, the chip-shaped workpiece is made to be easily peeled from the pressure-sensitive adhesive layer in a state where the die bonding adhesive layer is provided.

It is also preferable that a part of the portion other than the workpiece attachment portion is a dicing ring attachment portion.

It is also preferable that the adhesive strength of the die bonding adhesive layer to the dicing ring at the dicing ring attachment portion is smaller than the adhesive strength to the pressure-sensitive adhesive layer at the portion corresponding to the dicing ring attachment portion.

By making the above constitution, a dicing ring can be made to be easily peeled from the die bonding adhesive layer, and the dicing ring can be prevented from being peeled from the pressure-sensitive adhesive layer in a state where the die bonding adhesive layer is pasted onto the dicing ring.

It is also preferable that the die bonding adhesive layer is provided on a part of the pressure-sensitive adhesive layer as a workpiece attachment portion, and wherein the adhesive strength of a part corresponding to the workpiece attachment portion of the pressure-sensitive adhesive layer is smaller than the adhesive strength of the portion other than the workpiece attachment portion.

According to the above constitution, even in the case of a constitution where the die bonding adhesive layer is provided onto a part of the pressure-sensitive adhesive layer as the workpiece attachment portion, when picking-up a chip-shaped workpiece, the chip-shaped workpiece is made to be easily peeled from the pressure-sensitive adhesive layer in a state where the die bonding adhesive layer is provided.

It is also preferable that the adhesive strength of the die bonding adhesive layer to the workpiece at the workpiece attachment portion is greater than the adhesive strength to the pressure-sensitive adhesive layer at the portion corresponding to the workpiece attachment portion.

According to the above constitution, when picking-up a chip-shaped workpiece, the same as described above, the chip-shaped workpiece can be easily peeled from the pressure-sensitive adhesive layer in a state where the die bonding adhesive layer is provided.

It is also preferable that the pressure-sensitive adhesive layer is formed by a radiation curing type pressure-sensitive adhesive, and wherein the portion corresponding to the workpiece attachment portion is in a state of being cured by a radiation irradiation.

Further, the present invention relates to a method of fixing a chip-shaped workpiece using the dicing die-bonding film according to any one of claims 1 to 11, comprising the steps of:
compressing a workpiece onto the workpiece attachment portion of the die bonding adhesive layer;
dicing the workpiece together with the die bonding adhesive layer into a chip shape and stopping dicing at the pressure-sensitive adhesive layer;
peeling the chip-shaped workpiece together with the workpiece attachment portion of the die bonding adhesive layer from the pressure-sensitive adhesive layer; and
adhering and fixing the chip-shaped workpiece onto a semiconductor element interposing the workpiece attachment portion of the die bonding adhesive layer therebetween.

Since a dicing die-bonding film which includes a pressure-sensitive adhesive layer having a thickness of 10 to 80 µm and a storage elastic modulus at 23 °C of 1 x 10⁴ to 1 x 10¹⁰ Pa is used in the invention of the above method, when dicing the workpiece at least together with the die bonding adhesive layer into a chip shape, dicing is stopped at the pressure-sensitive adhesive layer, and the supporting substrate is made not to be cut. As a result, the generation of yarn-shaped scraps that are generated by cutting of the supporting substrate can be prevented.
Further, the workpiece can be suppressed from moving with vibration during dicing. As a result, chipping of the chip-shaped workpiece can be reduced. Further, since insufficiency of the adhesive strength of the pressure-sensitive adhesive layer to the die bonding adhesive layer is suppressed, the workpiece is certainly fixed onto the dicing die-bonding film and the generation of chip fly and positional shift during dicing are suppressed.

Further, the present invention relates to a semiconductor device, wherein the chip-shaped workpiece is adhered and fixed onto a semiconductor element interposing the workpiece attachment portion of the die bonding adhesive layer therebetween with the method of fixing the chip-shaped workpiece.

Further, the present invention relates to a method for manufacturing a semiconductor device using the dicing die-bonding film, comprising the steps of:
compressing a workpiece onto the workpiece attachment portion of the die bonding adhesive layer;
dicing the workpiece together with the die bonding adhesive layer into a chip shape and stopping dicing at the pressure-sensitive adhesive layer;
peeling the chip-shaped workpiece together with an adhesive in the die bonding adhesive layer from the pressure-sensitive adhesive layer; and
adhering and fixing the chip-shaped workpiece onto a semiconductor element interposing the adhesive therebetween.

Since a dicing die-bonding film which includes a pressure-sensitive adhesive layer having a thickness of 10 to 80 µm and a storage elastic modulus at 23 °C of 1 x 10⁴ to 1 x 10¹⁰ Pa is also used in the invention of the above method, the supporting substrate is prevented from being diced, and as a result, the generation of yarn-shaped scraps is prevented. Further, chipping of the chip-shaped workpiece during dicing can be reduced, and at the same time, the generation of chip fly and positional shift can be suppressed.

Further, the present invention relates to a semiconductor device, wherein the chip-shaped workpiece is adhered and fixed onto a semiconductor element interposing the adhesive in the die bonding adhesive layer therebetween with the method of manufacturing the semiconductor device.

### EFFECT OF THE INVENTION

The present invention has an effect as described below by way of the above means.
That is, since the dicing die-bonding film in the present invention has a pressure-sensitive adhesive layer having a thickness of 10 µm to 80 µm and a storage elastic modulus at 23 °C of 1 x 10⁴ to 1 x 10¹⁰ Pa, the supporting substrate is prevented from being cut when dicing the workpiece, and as a result, the generation of yarn-shaped scraps can be prevented. As a result, the chip-shaped workpiece can be prevented from being contaminated by such as attaching the yarn-shaped scraps.

### BRIEF DESCRIPTION OF THE DRAWINGS

- Fig. 1: is a cross-sectional schematic drawing showing one example of the dicing die-bonding film of the present invention.
- Fig. 2: is a cross-sectional schematic drawing to explain the relationship of peeling properties between the pressure-sensitive adhesive layer and the die bonding adhesive layer 3 in the above dicing die-bonding film.
- Fig. 3: is a cross-sectional schematic drawing showing another example of the dicing die-bonding film of the present invention.
- Fig. 4: is a plane drawing showing a state where a semiconductor wafer and a dicing ring are pasted onto the above dicing die-bonding film.
- Fig. 5: is a cross-sectional schematic drawing showing additionally another example of the dicing die-bonding film of the present invention.
- Fig. 6: is a cross-sectional schematic drawing showing an appearance when a workpiece is diced into a chip shape.

### EXPLANATION OF THE REFERENCE NUMERALS

- 1: = Supporting substrate
- 2: = Pressure-sensitive adhesive layer
- 2a: = Portion corresponding to workpiece attachment portion
- 2b: = Portion corresponding to a portion of the entirety other than workpiece attachment portion
- 3: = Die bonding adhesive layer
- 3a: = Workpiece attachment portion
- 3b: = Portion other than workpiece attachment portion
- 10: = Die bonding film
- 11: = Die bonding film
- 12: = Die bonding film
- 13: = Dicing blade

### BEST MODE FOR CARRYING OUT THE INVENTION

The embodiment of the present invention is explained with reference to the drawings. However, parts which are unnecessary in the explanation are not given, and there is a part which is shown in the drawings by such as enlarging or reducing in order to make the explanation easy.

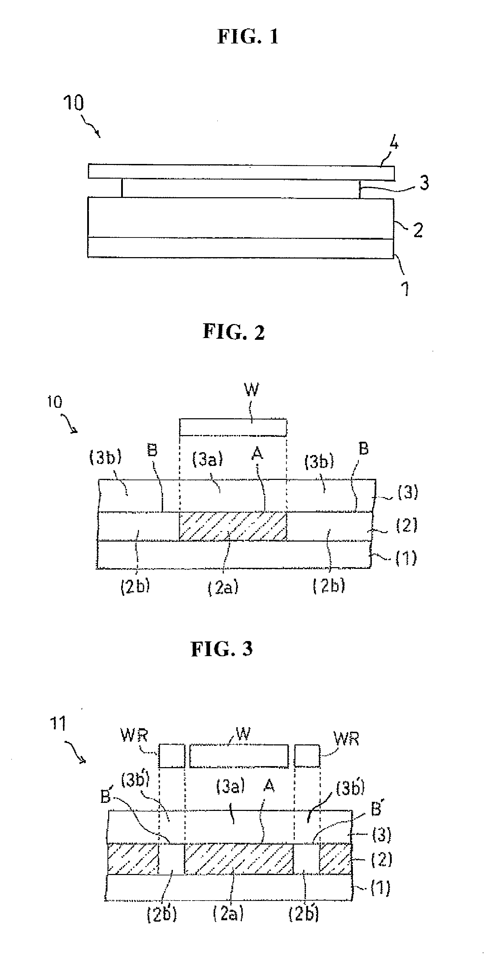

Fig. 1 is a cross-sectional schematic drawing showing one example of the dicing die-bonding film of the present invention. As shown in the drawing, a dicing die-bonding film 10 has a constitution in which a pressure-sensitive adhesive layer 2, a die bonding adhesive layer 3, and a peelable protective layer 4 are sequentially laminated on a supporting substrate 1.

The supporting substrate 1 confers strength on the dicing die-bonding film 10. Examples of the supporting substrate 1 is a plastic film that is composed of polyolefins such as low-density polyethylene, linear polyethylene, middle-density polyethylene, high-density polyethylene, ultra-low-density polyethylene, random copolymerization polypropylene, block copolymerization polypropylene, homopolypropylene, polybutene, polymethyl pentene etc., polyesters such as ethylene/vinyl acetate copolymer, ionomer resin, ethylene/(meth)acrylic acid copolymer, ethylene/(meth)acrylate (random, alternating) copolymer, ethylene/butane copolymer, ethylene/hexene copolymer, polyurethane, polyethylene terephthalate, polyethylene naphthalate etc., polycarbonate, polyimide, polyether ether ketone, polyimide, polyether imide, polyamide, every aromatic polyamide, polyphenyl sulfide, aramid (paper), glass, glass cloth, fluorine resin, polyvinyl chloride, polyvinylidene chloride, cellulose resin, silicone resin, mixture of those. The material of the supporting substrate includes polymers such as those crosslinked from the resin described above.

The supporting substrate 1 may be used in a non-stretched form or after subjection if necessary to uniaxial or biaxial stretching treatment. According to a resin sheet endowed with thermal shrinkability by stretching treatment, the supporting substrate 1 can be thermally shrunk after dicing thereby reducing the contact area between the pressure-sensitive adhesive layer 2 and the die bonding adhesive layer 3 to facilitate the recovery of chipped works.

The surface of the supporting substrate 1 can be subjected to ordinary surface treatment, for example chemical or physical treatment such as chromate treatment, ozone exposure, flame exposure, high-voltage electric shock exposure, ionization radiation treatment etc. or coating treatment such as a prime coating (for example, tacky substance described later) in order to increase the adhesiveness, retention etc. of its adjacent layer.

The same or different kinds of supporting substrate 1 can be suitably selected and used. The supporting substrate 1 may be a single layer or multilayer or may be a blend supporting substrate having two or more kinds of resins dry-blended therein. The multilayer film can be produced from the above resin etc. by a conventional film lamination method such as co-extrusion method, dry lamination method etc.
The supporting substrate 1 can be provided thereon with a evaporated layer of about 30 to 500 Å consisting of an electroconductive material such as a metal, an alloy and an oxide thereof in order to confer antistatic performance. The supporting substrate 1 may be a single layer or a multilayer consisting of two or more layers. When the pressure-sensitive adhesive layer 2 is a radiation-curing adhesive layer, the supporting substrate 1 permitting radiations such as X-ray, UV ray, electron beam etc. to pass therethrough at least partially is used.

Further, a pressure-sensitive adhesive film can be also made to have antistatic performance for the purpose of preventing the generation of static electricity during its adhesion, peeling off, etc., and a circuit from being broken down by charging of the semiconductor wafer due to the generation of static electricity, etc. The antistatic performance can be given with an appropriate manner such as adding an antistatic agent or a conductive agent to a support sheet or the pressure-sensitive adhesive layer, providing a charge transfer complex and a conductive layer composed of a metal film or the like to the support sheet, etc., and a manner is preferable in which impurity ions which might deteriorate the semiconductor wafer is hardly to be generated.

The thickness of the supporting substrate 1 is, for example, from about 5 µm to 200 µm, and is not particularly limited, as long as the thickness is such a thickness that the supporting substrate 1 can resist against tensile force based on the die-bonding adhesive layer 3 through the above-mentioned thermal contraction.

The above pressure-sensitive adhesive layer 2 has physical properties of being a thickness of 10 µm to 80 µm and a storage elastic modulus at 23 °C of 1 x 10⁴ to 1 x 10¹⁰ Pa. The reason why the thickness and the storage elastic modulus at 23 °C are made to be in the above numerical value range is to keep the cut depth during dicing in the range of the pressure-sensitive adhesive layer 2, and to prevent the cut depth from reaching to the supporting substrate 1.
The dicing condition in which the numerical value ranges of the thickness and the storage elastic modulus of the pressure-sensitive adhesive layer 2 sufficiently exhibit actions and effects of the present invention is the case where the dicing speed is in a range of 5 to 150 mm/sec and the rotation speed of the dicing blade is in a range of 25 000 rpm to 50 000 rpm for example.

Further, by making the storage elastic modulus at 23 °C in the above numerical value range, the generation of chipping can be prevented, and at the same time, the generation of chip fly and positional shift when picking-up the chip-shaped workpiece can be prevented also. The above storage elastic modulus is more preferably 1 x 10⁷ to 1 x 10¹⁰ Pa, and particularly preferably 1 x 10⁷ to 1 x 10⁹ Pa. When the storage elastic modulus is less than 1 x 10⁷ Pa, dicing to the supporting substrate 1 is easily performed, and the generation of yarn-shaped scraps increases.
Furthermore, the chip-shaped workpiece is easily moved in the dicing step, and therefore, chipping is generated. On the other hand, when it is greater than 1 x 10¹⁰ Pa, chip fly becomes easily generated in the dicing step, and in the die attaching step, chip fly and positional shift are generated when picking-up the chip-shaped workpiece. Furthermore, there is an increase of wear of the dicing blade, and the generation rate of chipping tends to become large.

Furthermore, the thickness of the pressure-sensitive layer 2 is made to be in the above numerical value range for preventing chipping of the chip cut surface, compatibility of fixing and holding of the die bonding adhesive layer 3 and the like. The thickness is more preferably 20 to 70 µm, further preferably 20 to 60 µm, and particularly preferably 20 to 50 µm.

The above pressure-sensitive layer 2 is constituted so that the peeling properties with the die bonding adhesive layer 3 has a relationship as follows (see Fig. 2). That is, between an interface A corresponding to a workpiece attachment portion 3a of the die bonding adhesive layer 3 (below, it may be referred to as die bonding adhesive layer 3a) and an interface B corresponding to a portion 3b other than the workpiece attachment portion 3b (below, it may be referred to as die bonding adhesive layer 3b), there is the relationship of the peeling properties of interface A > the peeling properties of interface B.
In order to satisfy this relationship, the pressure-sensitive adhesive layer 2 is designed so that the adhesive strength of a portion 2a corresponding to the workpiece attachment portion 3a (described later) (below, it may be referred to a pressure-sensitive adhesive layer 2a) < the adhesive strength of a portion 2b corresponding to a portion or the entirety other than the workpiece attachment portion (below, it may be referred to as pressure-sensitive adhesive layer 2b).

Based on the adhesive strength at a normal temperature (23 °C) (90 degree peel value, peeling rate of 300 mm/min), the adhesive strength of the above pressure-sensitive adhesive layer 2a is preferably 0.5 N/20 mm or less from the viewpoint of, further preferably 0.01 to 0.42 N/20 mm, and particularly preferably 0.01 to 0.35 N/20 mm from the viewpoint of the fixing and holding force of a wafer, recovery properties of a formed chip, etc.
On the other hand, the adhesive strength of the pressure-sensitive adhesive layer 2b is preferably about 0.5 to 20 N/20 mm. Even when the pressure-sensitive adhesive layer 2a has a low peel adhesive strength, the generation of chip fly, etc. is suppressed by the adhesive strength of the pressure-sensitive adhesive layer 2b, and a holding force can be exhibited that is sufficient for a wafer process.

As a method of making the adhesive strength different in plane of the pressure-sensitive adhesive layer 2, a use of a radiation curing type pressure-sensitive adhesive is included. By using the radiation curing type pressure-sensitive adhesive, if radiation is partially irradiated onto the pressure-sensitive adhesive layer 2, the degree of cross-linking of a polymer compound which constitutes the irradiating part can be increased, and as a result the adhesive strength can be decreased.
Therefore, in the present embodiment, the pressure-sensitive adhesive layer 2a is cured by irradiating radiation, and the adhesive strength is remarkably decreased. On the other hand, a sufficient adhesive strength is kept in the pressure-sensitive adhesive layer 2b without irradiating radiation. According to the above method, the pressure-sensitive adhesive layer 2 can support the die bonding adhesive layer 3 with a good balance of adhesion and peeling off. That is, an improvement of the pick-up properties can be attempted by sufficiently adhering the die bonding adhesive layer 3 with the pressure-sensitive adhesive layer 2b and by making peeling off of the die bonding adhesive layer 3 from the pressure-sensitive adhesive layer 2a easy.

The pressure-sensitive adhesive which constitutes the pressure-sensitive adhesive layer 2 is not particularly limited. However, a radiation curing type pressure-sensitive adhesive described above is suitable in the present invention. This is because a difference can be easily given to the adhesive strength between the pressure-sensitive adhesive layer 2a and the pressure-sensitive adhesive layer 2b. The radiation curing type pressure-sensitive adhesive can easily decrease the adhesive strength by increasing the degree of cross-linking by an irradiation of radiation such as ultraviolet rays.
Therefore, a region where the adhesive strength is remarkably decreased can be easily produced by irradiating radiation and curing the pressure-sensitive adhesive layer 2a corresponding to the workpiece attachment portion 3a. Since the workpiece attachment portion of the die bonding adhesive layer 3 is located in the pressure-sensitive adhesive layer 2a which is cured and in which the adhesive strength is decreased, an interface between the pressure-sensitive adhesive layer 2a and the workpiece attachment portion 3a has a characteristic of being peeled easily during pick-up.

On the other hand, since the pressure-sensitive adhesive layer 2b in which radiation is not irradiated is constituted by containing a non-cured radiation curing type pressure-sensitive adhesive, it has a sufficient adhesive strength. For this reason, the pressure-sensitive adhesive layer 2b is certainly adhered with the die bonding adhesive layer 3, and as a result, a holding force can be secured in which the die bonding adhesive layer 3 can be sufficiently fixed during dicing as the entire pressure-sensitive adhesive layer 2.
The pressure-sensitive adhesive layer 2 which is constituted by containing the radiation curing type pressure-sensitive adhesive in such way can support the die bonding adhesive layer 3 for fixing a substrate or an adherend such as a chip-shaped workpiece (referred to as a semiconductor chip) with a good balance of adhesion and peeling off.

The pressure-sensitive adhesive which constitutes the pressure-sensitive adhesive layer 2 is not particularly limited. However, a radiation curing type pressure-sensitive adhesive is suitable in the present invention. A radiation curing type pressure-sensitive adhesive having a radiation curable functional group such as a carbon-carbon double bond and which shows adherability can be used particularly without limitation.

Example of the radiation curing type pressure-sensitive adhesive include a radiation curing type pressure-sensitive adhesive of the addition type in which a radiation curable monomer component or a radiation curable oligomer component is compounded into a general pressure-sensitive adhesive such as the above acryl pressure-sensitive adhesive, a rubber pressure-sensitive adhesive, a silicone pressure-sensitive adhesive, and a polyvinylether pressure-sensitive adhesive. The above pressure-sensitive adhesive is preferably an acryl pressure-sensitive adhesive having an acryl polymer as a base polymer from the viewpoint of clean washing properties of electric parts which should not be contaminated such as a semiconductor wafer and a glass with ultrapure water and an organic solvent such as alcohol.

Examples of the acrylic polymer include acrylic polymers each comprising, as one or more monomer components, one or more selected from alkyl esters of (meth)acrylic acid (for example, linear and branched alkyl esters thereof each having an alkyl group having 1 to 30 carbon atoms, in particular, 4 to 18 carbon atoms, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester thereof) and cycloalkyl esters of (meth)acrylic acid (for example, cyclopentyl ester and cyclohexyl ester thereof). The wording "esters of (meth)acrylic acid" means esters of acrylic acid and/or methacrylic acid. All of the words including "(meth)" in connection with the present invention have an equivalent meaning.

The acrylic polymer may optionally contain a unit corresponding to a different monomer component copolymerizable with the above-mentioned alkyl ester of (meth)acrylic acid or cycloalkyl ester thereof in order to improve the cohesive force, heat resistance or some other property of the polymer. Examples of such a monomer component include carboxyl-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride, and itaconic anhydride; hydroxyl-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxylmethylcyclohexyl)methyl (meth)acrylate; sulfonic acid group containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group containing monomers such as 2-hydroxyethylacryloyl phosphate; acrylamide; and acrylonitrile. These copolymerizable monomer components may be used alone or in combination of two or more thereof. The amount of the copolymerizable monomer(s) to be used is preferably 40 % or less by weight of all the monomer components.

For crosslinking, the acrylic polymer can also contain multifunctional monomers if necessary as the copolymerizable monomer component. Such multifunctional monomers include hexane diol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylol propane tri(meth)acrylate, pentaerythritol tri(meth)acrylate, dipentaerythritol hexa(meth)acrylate, epoxy (meth)acrylate, polyester (meth)acrylate, urethane (meth)acrylate etc. These multifunctional monomers can also be used as a mixture of one or more thereof. From the viewpoint of adhesiveness etc., the use amount of the multifunctional monomer is preferably 30 wt% or less based on the whole monomer components.

Preparation of the above acryl polymer can be performed by applying an appropriate manner such as a solution polymerization manner, an emulsion polymerization manner, a bulk polymerization manner, and a suspension polymerization manner to a mixture of one or two or more kinds of component monomers for example. Since the pressure-sensitive adhesive layer preferably has a composition in which the content of low molecular weight materials is suppressed from the viewpoint of prevention of wafer contamination, and since those in which an acryl polymer having a weight average molecular weight of 300 000 or more, particularly 400 000 to 30 000 000 is as a main component are preferable from such viewpoint, the pressure-sensitive adhesive can be made to be an appropriate cross-linking type with an internal cross-linking manner, an external cross-linking manner, etc.

Further, in order to control cross-linking density of the pressure-sensitive adhesive layer 2, an appropriate manner can be adopted such as a manner of performing a cross-linking process using an appropriate external cross-linking agent such as a multi-functional isocyanate compound, an epoxy compound, a melamine compound, a metal salt compound, a metal chelate compound, an amino resin compound, and a peroxide, a manner of performing a cross-linking process by mixing low molecular compounds having two or more carbon-carbon double bonds and irradiating energy rays, etc., or the like.
In the case of using an external cross-linking agent, the amount used is appropriately determined by a balance with the base polymer which should be cross-linked and further by the use as a pressure-sensitive adhesive. Generally, it is compounded about 5 parts by weight or less, and further preferably 0.1 to 5 parts by weight based on 100 parts by weight of the above base polymer. Here, various tackifiers and an additive such as an antioxidant may be used in the pressure-sensitive adhesive besides the above components, if necessary.

Examples of the radiation curable monomer component which is compounded include such as urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate.

Further, examples of the radiation curable oligomer component include various oligomers such as urethane oligomers, polyether oligomers, polyester oligomers, polycarbonate oligomers, polybutadiene oligomers, and its molecular weight is appropriately in a range of about 100 to 30 000. The amount of the radiation curable monomer component and oligomer component compounded can be appropriately determined to an amount of which the adhesive strength of the pressure-sensitive adhesive layer can be decreased depending on the kind of the above pressure-sensitive adhesive layer. Generally, it is 5 to 500 parts by weight, and preferably about 70 to 150 parts by weight based on 100 parts by weight of the base polymer such as the acryl polymer which constitutes the pressure-sensitive adhesive.

The radial ray curable adhesive may be the above-mentioned additive type radial ray curable adhesive, or an intrinsic type radial ray curable adhesive comprising, as a base polymer, a polymer having a carbon-carbon double bond in a side chain thereof, the main chain thereof, or a main chain terminal thereof. The intrinsic type radial ray curable adhesive is preferable for the following reason: the adhesive does not need to contain any oligomer component or the like, which is a low molecular weight component, or does not contain a large amount thereof; therefore, no oligomer component or the like moves into the adhesive layer with the passage of time so that the layer structure of the adhesive layer can be kept stable.

The above-mentioned base polymer, which has a carbon-carbon double bond, may be any polymer that has a carbon-carbon double bond and further has viscosity. As such a base polymer, a polymer having an acrylic polymer as a basic skeleton is preferable. Examples of the basic skeleton of the acrylic polymer include the acrylic polymers exemplified above.

The method for introducing a carbon-carbon double bond into any one of the above-mentioned acrylic polymers is not particularly limited, and may be selected from various methods. The introduction of the carbon-carbon double bond into a side chain of the polymer is easier in molecule design. The method is, for example, a method of copolymerizing a monomer having a functional group with an acrylic polymer, and then causing the resultant to condensation-react or addition-react with a compound having a functional group reactive with the above-mentioned functional group and a carbon-carbon double bond while keeping the radial ray curability of the carbon-carbon double bond.

Examples of the combination of these functional groups include a carboxylic acid group and an epoxy group; a carboxylic acid group and an aziridine group; and a hydroxyl group and an isocyanate group. Of these combinations, the combination of a hydroxyl group and an isocyanate group is preferable from the viewpoint of the easiness of reaction tracing. If the above-mentioned acrylic polymer, which has a carbon-carbon double bond, can be produced by the combination of these functional groups, each of the functional groups may be present on any one of the acrylic polymer and the above-mentioned compounds.
It is preferable for the above-mentioned preferable combination that the acrylic polymer has the hydroxyl group and the above-mentioned compound has the isocyanate group. Examples of the isocyanate compound in this case, which has a carbon-carbon double bond, include methacryloyl isocyanate, 2-methacryloyloxyethyl isocyanate, and m-isopropenyl-a,a-dimethylbenzyl isocyanate. The used acrylic polymer may be an acrylic polymer copolymerized with any one of the hydroxyl-containing monomers exemplified above, or an ether compound such as 2-hydroxyethyl vinyl ether, 4-hydroxybutyl vinyl ether or diethylene glycol monovinyl ether.

The intrinsic type radial ray curable adhesive may be made only of the above-mentioned base polymer (in particular, the acrylic polymer), which has a carbon-carbon double bond. However, the above-mentioned radial ray curable monomer component or oligomer component may be incorporated into the base polymer to such an extent that properties of the adhesive are not deteriorated. The amount of the radial ray curable oligomer component or the like is usually 30 parts or less by weight, preferably from 0 to 10 parts by weight for 100 parts by weight of the base polymer.

In the case that the radial ray curable adhesive is cured with ultraviolet rays or the like, a photopolymerization initiator is incorporated into the adhesive. Examples of the photopolymerization initiator include α-ketol compounds such as 4-(2-hydroxyethoxy)phenyl(2-hydroxy-2-propyl)ketone, α-hydroxy-α,α'-dimethylacetophenone, 2-methyl-2-hydroxypropiophenone, and 1-hydroxycyclohexyl phenyl ketone; acetophenone compounds such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether compounds such as benzoin ethyl ether, benzoin isopropyl ether, and anisoin methyl ether; ketal compounds such as benzyl dimethyl ketal; aromatic sulfonyl chloride compounds such as 2-naphthalenesulfonyl chloride; optically active oxime compounds such as 1-phenone-1,1-propanedione-2-(o-ethoxycarbonyl)oxime; benzophenone compounds such as benzophenone, benzoylbenzoic acid, and 3,3'-dimethyl-4-methoxybenzophenone; thioxanthone compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphonoxides; and acylphosphonates. The amount of the photopolymerization initiator to be blended is, for example, from about 0.05 to 20 parts by weight for 100 parts by weight of the acrylic polymer or the like which constitutes the adhesive as a base polymer.

Further, examples of the radiation curing type pressure-sensitive adhesive which is used in the formation of the pressure-sensitive adhesive layer 2 include such as a rubber pressure-sensitive adhesive or an acryl pressure-sensitive adhesive which contains an addition-polymerizable compound having two or more unsaturated bonds, a photopolymerizable compound such as alkoxysilane having an epoxy group, and a photopolymerization initiator such as a carbonyl compound, an organic sulfur compound, a peroxide, an amine, and an onium salt compound, which are disclosed in JP-A- 60-196 956. Examples of the above addition-polymerizable compound having two or more unsaturated bonds include such as polyvalent alcohol ester or oligoester of acryl acid or methacrylic acid and an epoxy or a urethane compound.

The amount of the above photopolymerizable compound or the photopolymerization initiator compounded is generally 10 to 500 parts by weight, and preferably 0.05 to 20 parts by weight, respectively, based on 100 parts by weight of the base polymer. Other than these compounded components, an epoxy group functional cross-linking agent having one or two or more epoxy groups in a molecule such as ethylene glycol diglycidylether may be additionally compounded if necessary to increase cross-linking efficiency of the pressure-sensitive adhesive.

A compound which is colored by irradiating radiation can be also included in the pressure-sensitive adhesive layer 2 in which the above radiation curing type pressure-sensitive adhesive is contained, if necessary. By including a compound which is colored by irradiating radiation into the pressure-sensitive adhesive layer 2, only a portion which is irradiated with radiation can be colored. According to this process, the pressure-sensitive adhesive layer 2a corresponding to the workpiece attachment portion 3a can be also colored for example.
As a result, whether radiation is irradiated onto the pressure-sensitive adhesive layer 2 or not can be visually identified directly, the workpiece attachment portion 3a becomes easily recognized, and pasting of the workpiece becomes easy. Further, when detecting a semiconductor element by an optical sensor, etc., its detection accuracy improves, and there is no false operation during picking-up of the semiconductor element.

The compound colored by irradiation with radial rays is a compound which is colorless or has a light color before the irradiation with radical rays but comes to have a color by the irradiation. A specific example thereof is preferably a leuco dye. Preferable examples of the leuco dye include conventional triphenylmethane type, fluoran type, phenothiazine type, auramine type, and spiropyran type dyes. Specific examples thereof include 3-[N-(p-tolylamino)]-7-anilinofluoran, 3-[N-(p-tolyl)-N-methylamino]-7-anilinofluoran, 3-[N-(p-tolyl)-N-ethylamino]-7-anilinofluoran, 3-diethylamino-6-methyl-7-amlinofluoran, crystal violet lactone, 4,4',4"-trisdimethylaminotriphenylmethanol, and 4,4',4"-trisdimethylaminotriphenylmethane.

A color developer which is preferably used together with any one of these leuco dyes may be a conventionally-used electron acceptor, such as an initial polymer of phenol formalin resin, an aromatic carboxylic acid derivative, or active white clay. In the case that the color tone of the dye is changed, combinations thereof with various known color formers may be used.

Such compound which is colored by irradiating radiation may be included in the radiation curing type pressure-sensitive adhesive after being dissolved into an organic solvent, etc. once, or may be made into a fine powder to be included into the pressure-sensitive adhesive layer 2. In the used ratio of this compound, it is desirably used at an amount of 0.01 to 10 % by weight, and preferably at an amount of 0.5 to 5 % by weight in the pressure-sensitive adhesive layer 2.
When the ratio of the compound exceeds 10 % by weight, the radiation which is radiated to the pressure-sensitive adhesive layer 2 is excessively absorbed by this compound, and therefore curing of the above pressure-sensitive adhesive layer 2a becomes insufficient, and the adhesive strength may not sufficiently decrease. On the other hand, when the used ratio of the compound is an amount of less than 0.01 % by weight, the pressure-sensitive adhesive sheet may not be sufficiently colored during irradiating radiation, and a false operation may be easily generated during pick-up of the semiconductor element.

In the case of forming the pressure-sensitive layer 2 with the radiation curing type pressure-sensitive adhesive, a method can be included for forming the pressure-sensitive adhesive layer 2a by partially irradiating radiation onto a portion corresponding to the workpiece attachment portion 3a and curing after forming the pressure-sensitive adhesive layer 2 of radiation curing type on the supporting substrate 1. The partial irradiation of radiation can be performed through a photo mask in which a pattern is formed corresponding to a portion other than the workpiece attachment portion 3a (such as 3b).
Further, a method or the like can be included for irradiating ultraviolet rays onto a spot and curing. The formation of the pressure-sensitive adhesive layer 2 of a radiation curing type can be performed by transferring those which are provided on a separator onto the supporting substrate 1. The partial radiation curing can be also performed on the pressure-sensitive adhesive layer 2 of a radiation curing type which is provided on the separator.

Further, in the case of forming the pressure-sensitive adhesive layer 2 with a radiation curing type pressure-sensitive adhesive, the pressure-sensitive adhesive layer 2a in which the adhesive strength is decreased can be formed by using the supporting substrate 1 of which the entirety or a part of a portion other than a portion corresponding to the workpiece attachment portion 3a on at least one surface of the supporting substrate 1 is shaded, irradiating radiation after forming the pressure-sensitive adhesive layer 2 of a radiation curing type onto this, and then curing a portion corresponding to the workpiece attachment portion 3a.
A shading material which can become a photo mask on the support film can be used as the shading material, and can be formed with printing, vapor deposition, etc. According to such manufacturing method, the dicing die-bonding film of the present invention can be manufactured with efficiency.

Here, in the case where a curing obstruction occurs by oxygen when irradiating radiation, it is desirable to shield oxygen (air) from the surface of the pressure-sensitive adhesive layer of a radiation curing type with some method. Examples include such as a method of coating the surface of the above pressure-sensitive adhesive layer 2 with a separator or a method of performing irradiation of radiation such as ultraviolet rays in a nitrogen gas atmosphere.

The thickness of the pressure-sensitive adhesive layer 2 is not particularly limited. However, it is preferably about 1 to 50 µm from the viewpoint of preventing chipping of the chip cut surface, compatibility of fixing and holding of the adhesive layer, and the like. It is preferably 2 µm to 30 µm, and further preferably 5 µm to 25 µm.

The die bonding adhesive layer 3 has a function of supporting the workpiece by closely adhering when the workpiece (such as semiconductor wafer) which is adhered with pressure onto the layer is cut in a chip-shape and acting as an adhesive layer of the cut piece and a substrate or a chip-shaped cut workpiece when the chip-shaped cut workpiece (such as a semiconductor chip) is mounted. Particularly, it is important to have tackiness to a degree in which the cut pieces do not scatter when cutting the workpiece as the die bonding adhesive layer 3.

The die-bonding adhesive layer 3 can be formed from an ordinary die-bonding adhesive. The die-bonding adhesive is preferably a die-bonding adhesive which can be made into a sheet form. A specific example of the die-bonding adhesive is preferably a die-bonding adhesive made of a thermoplastic resin or a thermosetting resin. The die-bonding adhesive may be made of one or more selected from die-bonding adhesives. The die-bonding adhesive layer 3 is preferably a layer which can be stuck onto the semiconductor wafer at 70 °C or lower, more preferably a layer which can be done at room temperature.

Examples of the thermoplastic resin used as the die-bonding adhesive (thermoplastic die-bonding adhesive) include saturated polyester resin, thermoplastic polyurethane resin, amide type resin (nylon type resin), and imide type resin. Examples of the thermosetting resin (thermosetting die-bonding adhesive) include epoxy resin, unsaturated polyester resin, thermosetting acrylic resin, and phenol resin.
The thermosetting resin is preferably a thermosetting resin which is subjected to solvent-removing treatment so as to be turned into a sheet or turned into a B-stage (temporarily cured). A mixture of any one of these thermosetting resins and any one of these thermoplastic resins can also be used in a temporarily-cured state. In the present invention, a silicone type, rubber type, urethane type, imide type, or acrylic type resin, or some other type resin having a high glass transition temperature can also be used as the die-bonding adhesive.

Further, a conductive material (a conductive filler) may be compounded in the die bonding adhesive layer 3 for the purposes of giving conductivity, improving thermal conductivity, etc. Example of the conductive material include such as sphere-shaped, needle-shaped, and flake-shaped metal powders of silver, aluminum, gold, copper, nickel, conductive alloys, etc., a metal oxide of alumina, etc., amorphous carbon black, and graphite.

The die-bonding adhesive layer 3 may have a multi-layered structure having two or more layers made of an appropriate combination selected from thermoplastic resins having different glass transition temperatures and thermosetting resins having different thermosetting temperatures. Since cutting water is used in the step of dicing the workpiece (such as semiconductor wafer), the die-bonding adhesive layer 3 may absorb humidity to have a larger water content than the layer 3 in an ordinary state.
If the layer 3 having such a high water content is stuck, as it is, onto a substrate or the like, water vapor remains in the adhesive interface at the stage of after-curing so that the layer 3 may float. Accordingly, the die-bonding adhesive layer 3 is made into a structure wherein a film having a high moisture permeability is sandwiched between die-bonding adhesives, whereby water vapor can be diffused through the film at the after-curing stage to avoid the above-mentioned problem. Therefore, the die-bonding adhesive layer 3 may have a multi-layered structure wherein an adhesive layer, a film and another adhesive layer are laminated in this order.

The die bonding adhesive layer 3 is equipped with a function of adhering and holding the workpiece (such as semiconductor wafer) during dicing and a function of adhering and fixing the chip-shaped cut workpiece (such as semiconductor wafer) onto an adherend such as a substrate. The thickness is not particularly limited. However, it is 1 µm to 100 µm for example, preferably 3 µm to 70 µm, and preferably about 5 µm to 50 µm.

The die bonding adhesive layer 3 is preferably designed so that the adhesive strength to the workpiece of the workpiece attachment portion 3a and the adhesive strength to the pressure-sensitive adhesive layer 2a becomes the adhesive strength to the workpiece > the adhesive strength to the pressure-sensitive adhesive layer 2a. The adhesive strength to the workpiece is appropriately adjusted depending on the kind of the workpiece.

The adhesive strength of the workpiece attachment portion 3a to the pressure-sensitive adhesive layer 2a (90 degree peel value, peeling rate of 300 mm/min) is preferably 0.5N/20 mm or less, further preferably 0.01 to 0.42 N/20 mm, and particularly preferably 0.01 to 0.35 N/20 mm as described above. On the other hand, the adhesive strength to the workpiece of the workpiece attachment portion 3a (same condition as described above) is preferably 10 to 50 N/20 mm or less, and further preferably 10 to 30 N/20 mm from the viewpoint of reliability during dicing, picking-up, and die-bonding and pick-up properties.

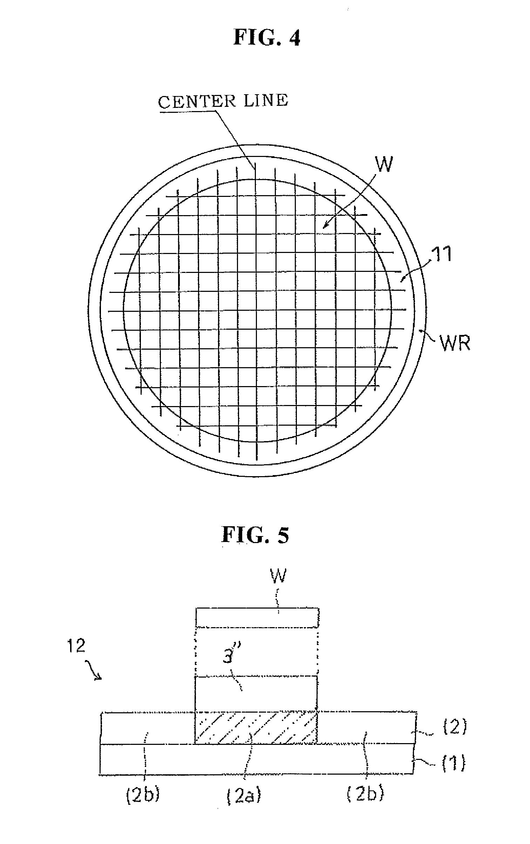

The dicing die-bonding film of the present invention can adopt the following constitution in the case of using a dicing ring (wafer ring) when dicing a semiconductor wafer as a workpiece. Fig. 3 is a cross-sectional schematic drawing showing another example of the dicing die-bonding film in the present invention. Fig. 4 is a plane drawing showing a state where a semiconductor wafer and a dicing ring are pasted onto the dicing die-bonding film.
As shown in Fig. 3, a dicing die-bonding film 11 has a constitution of having a pressure-sensitive layer 2' on the supporting substrate 1, and a die bonding adhesive layer 3' on the pressure-sensitive adhesive layer 2'. The die bonding adhesive layer 3' is provided with a dicing ring attachment portion 3b' on a part of the above portion 3b. Further, the pressure-sensitive adhesive later 2' is provided with a portion 2b' corresponding to the dicing ring attachment portion 3b' (may be referred to as pressure-sensitive adhesive layer 2b').
Furthermore, the pressure-sensitive adhesive layer 2' is designed so that the peeling strength of an interface **B**' of the dicing ring attachment portion 3b' and the pressure-sensitive adhesive layer 2b' which is formed corresponding to the dicing ring attachment portion has a relationship of the peeling strength of interface **A** greater than the peeling strength of interface **B'**. Here, the entire pressure-sensitive adhesive layer 2 in Fig. 2 other than the pressure-sensitive adhesive layer 2a becomes the pressure-sensitive adhesive layer 2b. However, as shown in Fig. 3, a portion other than the pressure-sensitive adhesive layer 2a can be also made to be the pressure-sensitive adhesive layer 2b'.

When the region 3b other than the workpiece attachment region 3a is used as the dicing attachment region 3b' in the dicing die-bonding film 11, the adhesions of the dicing attachment region 3b' in the die-bonding adhesive layer 3 to the workpiece and to the pressure-sensitive adhesive layer 2b' are designed preferably such that the adhesion to the dicing ring is lower than the adhesion to the pressure-sensitive adhesive layer 2b'. The adhesion to the dicing ring is regulated suitably depending on the type of the dicing ring.

The adhesive strength of the die bonding adhesive layer 3' to the pressure-sensitive adhesive layer 2b' (same condition as described above) is preferably about 0.5 to 20 N/20 mm as described above. On the other hand, the adhesive strength of the die bonding adhesive layer 3' to the dicing ring (same condition as described above) is preferably 0.3 to 5 N/20 mm, and further preferably 0.5 to 5 N/20 mm from the viewpoint of workability during dicing and die bonding.

The pressure-sensitive adhesive layer 2a corresponding to the workpiece attachment portion 3a and the pressure-sensitive adhesive layer 2b' other than the workpiece attachment portion in the pressure-sensitive adhesive layer 2' are designed to have the adhesive strength of the pressure-sensitive adhesive layer 2a < the adhesive strength of the pressure-sensitive adhesive layer 2b'. The adhesive strength of the pressure-sensitive adhesive layer 2a to the workpiece attachment portion 3a (same condition as described above) is preferably 0.5 N/20 mm or less, further preferably 0.01 to 0.42 N/20 mm, and particularly preferably 0.01 to 0.35 N/20 mm, as described above.

The dicing die-bonding film of the present invention may have a constitution in which the die bonding adhesive layer is provided only in a portion where the workpiece is pasted on the pressure-sensitive adhesive layer 2. Fig. 5 is a cross-sectional schematic drawing showing additionally another example of the dicing die-bonding film of the present invention. As shown in Fig. 5, a dicing die-bonding film 12 has a constitution having the pressure-sensitive adhesive layer 2 on a supporting substrate 1 and a die bond adhesive layer 3" on the pressure-sensitive adhesive layer 2.

The adhesive strength of the die bonding adhesive layer 3" to the pressure-sensitive adhesive layer 2a (same condition as described above) is preferably 0.5 to 20 N/20 mm or less, further preferably 0.01 to 0.42 N/20 mm, and particularly preferably 0.01 to 0.35 N/20 mm, as described above. On the other hand, the adhesive strength of the die bonding adhesive layer 3" to the workpiece (same condition as described above) is preferably 10 to 50 N/20 mm or less, and further preferably 10 to 30 N/20 mm from the viewpoint of reliability during dicing, picking-up and die bonding and pick-up properties.

The die bonding adhesive layers 3 and 3" of the above dicing die-bonding films 10 to 12 may be protected by a protective layer 4. That is, the protective layer 4 can be provided arbitrarily. The protective layer 4 has a function as a protective material which protects the die bonding adhesive layers 3 and 3" until they are put into practical use. Here, the protective layer 4 can be used as a supporting substrate when the die bonding adhesive layers 3 and 3a are transferred onto the pressure-sensitive adhesive layer 2.
The protective layer 4 is peeled when pasting the workpiece onto the die bonding adhesive layers 3 and 3" of the dicing die-bonding films 11 and 12. Example of the protective layer 4 include such as a plastic film and a paper in which the surface is coated with a peeling agent such as polyethylene, polypropylene, a fluorine peeling agent, or a long-chain alkylacrylate peeling agent.

The dicing die-bonding films 10 to 12 of the present invention is used as follows by peeling appropriately a separator which is arbitrarily provided on the die bonding adhesive layers 3 and 3". That is, the workpiece is adhered with pressure onto the die bonding adhesive layer 3a (3") of the dicing die-bonding films 10 to 12, and this is fixed by adhering and holding. The adhesion with pressure is performed with a normal method. Examples of the workpiece which is an adherend and which can be used include such as a semiconductor wafer, a multi-layer substrate, and a collectively sealing module. In the present invention, a semiconductor wafer can be suitably used as the adherend or the workpiece.

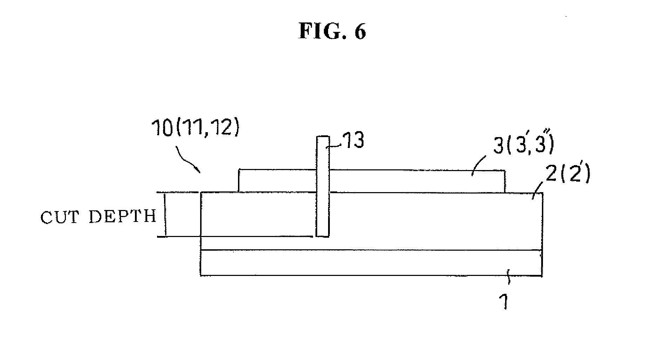

Next, as shown in Fig. 6, the workpiece is diced into a chip shape. Fig. 6 is a cross-sectional schematic drawing showing an appearance of dicing. The dicing is performed until at least the die bonding adhesive layer 3 (3') is cut completely. For the pressure-sensitive adhesive layer 2 (2'), dicing is performed until the cut depth by a dicing blade 13 becomes a prescribed value, and so that it does not reach to the supporting substrate 1. Examples of the workpiece include such as a semiconductor wafer, a multi-layer substrate, and a collectively sealing module. The dicing makes the workpiece including the die bonding adhesive layer 3 into a chip-shaped workpiece (such as a semiconductor chip) with an appropriate means by a rotary round blade, etc.

Consequently, the chip-shaped workpiece is peeled from the pressure-sensitive adhesive layer 2a of the pressure-sensitive adhesive layer 2 together with the workpiece pasting part 3a of the die bonding adhesive layer 3 (or the die bonding adhesive layer 3"). The chip-shaped workpiece which is picked-up is adhered and fixed to a semiconductor element which is the adherend through such as the workpiece attachment portion 3a interposed therebetween. Examples of the semiconductor element include such as a lead frame, a TAB film, a substrate, and a chip-shaped workpiece which is separately produced.
The adherend may be a deforming type adherend which can be easily deformed for example, or may be a non-deforming type adherend which is difficult to be deformed (such as a semiconductor wafer). A semiconductor wafer is suitable as the adherend. In the case where the die bonding adhesive layers 3, 3', and 3" are a thermosetting type, heat resistance strength is improved by adhering and fixing the workpiece to the adherend with heat curing. Here, those in which the chip-shaped workpiece is adhered and fixed to a substrate, etc. through the die bonding adhesive layers 3a and 3" interposed therebetween can be used in a reflow step.

Further, the dicing die-bonding films 10 to 12 can have antistatic performance for the purpose of preventing generation of static electricity during its adhesion, peeling, etc., and preventing a circuit from being broken down by charging of the workpiece (such as a semiconductor wafer) due to the generation of static electricity, etc. The antistatic performance can be given with an appropriate manner such as adding an antistatic agent or a conductive material into the supporting substrate 1, the pressure-sensitive adhesive layers 2 and 2', or the die bonding adhesive layers 3, 3', and 3" or providing a charge transfer complex or a conductive layer composed of a metal film or the like to the supporting substrate 1.
As these manners, a manner is preferable in which impurity ions which might deteriorate the semiconductor wafer is hardly to be generated. Example of a conductive material (a conductive filler) which is compounded for a purpose of giving conductivity, improving thermal conductivity, etc. include such as sphere-shaped, needle-shaped, and flake-shaped metal powders of silver, aluminum, gold, copper, nickel, conductive alloys, etc., a metal oxide of alumina, etc., amorphous carbon black, and graphite.

### EXAMPLES

Preferred examples of this invention will be illustratively described in detail hereinafter. However, materials, blend amounts and others that will be described in the Examples do not limit to this invention unless any restrictive description is particularly included. Thus, these are mere explanatory examples.

### Example 1

A pressure-sensitive adhesive layer having a thickness of 20 µm was formed by applying a solution of an acryl pressure-sensitive adhesive which can be cured with ultraviolet rays onto a supporting substrate composed of a polyethylene film having a thickness of 60 µm and drying. Thereafter, only the portion where a wafer is pasted was irradiated with ultraviolet rays at 500 mJ/cm² through a mask, and a pressure-sensitive adhesive film A was obtained composed of this supporting substrate and the pressure-sensitive adhesive layer in which a portion which is pasted to a wafer was cured with ultraviolet rays. A method of measuring the thickness of the pressure-sensitive adhesive layer and the irradiation condition of the ultraviolet rays are described later.

Preparation of the solution of the acryl pressure-sensitive adhesive which can be cured with the ultraviolet rays was performed as follows. That is, an acryl polymer having a weight average molecular weight of 800 000 was obtained by co-polymerizing 70 parts by weight of butylacrylate, 30 parts by weight of ethylacrylate, and 5 parts by weight of acrylic acid in ethylacetate in a conventional method. Next, a solution of the acryl pressure-sensitive adhesive having a concentration of 30% by weight was obtained by compounding 0.5 parts by weight of a multi-functional epoxy compound as a cross-linking agent, 20 parts by weight of dipentaerythritol monohydroxy pentaacrylate as a photopolymerizable compound, and 1 part by weight of α-hydroxycyclohexylphenylketone as a photopolymerization initiator to 100 parts by weight of this acryl polymer and uniformly dissolving them into toluene as an organic solvent.

Here, the storage elastic modulus at 23 °C of the pressure-sensitive adhesive film A was measured. As a result, it was 3 x 10⁸ Pa. Details of the measurement method will be described later.

Next, production of the die bonding adhesive layer was performed. That is, 3 parts by weight of a multi-functional isocyanate cross-linking agent, 23 parts by weight of an epoxy resin (Epicoat 1004, manufactured by Japan Epoxy Resins Co., Ltd.), and 6 parts by weight of a phenol resin (MILEX XLC-LL, manufactured by Mitsui Chemicals, Inc.) based on 100 parts by weight of an acrylic acid ester polymer having ethylacrylate-methylmetacrylate as a main component (PARACRON W-197CM, manufactured by Negami Chemical Industrial Co., Ltd.) were dissolved into methylethylketone, and the concentration was adjusted to 20 % by weight.

This solution of the adhesive composition was applied onto a mold-releasing process film composed of a polyethylene terephthalate film having a thickness of 50 µm, Thereafter, it was dried at 120 °C for 3 minutes to form a die bonding adhesive layer A having a thickness of 20 µm. Here, as the mold-releasing process film, those in which a silicone mold-releasing process was performed on a polyethylene terephthalate film were used.

Consequently, the die bonding adhesive layer **A** was transferred to the pressure-sensitive adhesive layer side on the pressure-sensitive adhesive film **A** composed of the above acryl pressure-sensitive adhesive to obtain the dicing die-bonding film according to the present example was obtained.

### Example 2

In the present example, the dicing die-bonding film according to the present example was produced in the same method as in Example 1 except that a polymer having butylacrylate as a main component (PARACRON SN-710, manufactured by Negami Chemical Industrial Co., Ltd.) was used in place of the acrylic acid ester polymer having ethylacrylate-methylmethacrylate as a main component and the thickness of the pressure-sensitive adhesive film A was changed to 30 µm.

### Example 3

A pressure-sensitive adhesive layer having a thickness of 70 µm was formed by applying a solution of an acryl pressure-sensitive adhesive which can be cured with ultraviolet rays onto a supporting substrate composed of a polyethylene film having a thickness of 80 µm and drying. Thereafter, only the portion where a wafer is pasted was irradiated with ultraviolet rays at 500 mJ/cm² through a mask, and a pressure-sensitive adhesive film **B** was obtained composed of this supporting substrate and the pressure-sensitive adhesive layer in which a portion which is pasted to a wafer was cured with ultraviolet rays. The irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of 500 000 was obtained by co-polymerizing a compounded composition composed of 50 parts by weight of ethylacrylate, 50 parts by weight of butylacrylate, and 16 parts by weight of 2-hydroxyethylacrylate in a toluene solution.

Next, a carbon-carbon double bond was introduced into a side chain in the polymer molecule by subjecting 20 parts by weight of 2-methacryloyloxyethylisocyanate to addition reaction based on 100 parts by weight of this acryl polymer. The length of the side chain at this time was 13 atoms in number of atoms. A solution of the acryl pressure-sensitive adhesive having a concentration of 20 % by weight was obtained by further compounding 1 part by weight of a multi-functional isocyanate cross-linking agent and 3 parts by weight of an acetophenone photopolymerization initiator based on100 parts by weight of this polymer and uniformly dissolving them into toluene as an organic solvent.

Here, the storage elastic modulus at 23 °C of the pressure-sensitive adhesive film B was measured. As a result, it was 4 x 10⁷ Pa. Here, details of the measurement method will be described later.

Next, production of the die bonding adhesive layer **A** was performed in the same method as in Example 1 except that the thickness was changed to 10 µm. Consequently, the die bonding adhesive layer **A** was transferred to the pressure-sensitive adhesive layer side on the pressure-sensitive adhesive film **B** composed of the above acryl pressure-sensitive adhesive to obtain the dicing die-bonding film according to the present example.

### Comparative Example 1

The dicing die-bonding film according to the present example was produced in the same method as in Example 1 except that the thickness of the pressure-sensitive adhesive layer was made to be 100 µm.

### Comparative Example 2

The dicing die-bonding film according to the present example was produced in the same method as in Example 3 except that the thickness of the pressure-sensitive adhesive layer was made to be 3 µm.

### Comparative Example 3

A pressure-sensitive adhesive layer having a thickness of 30 µm was formed by applying a solution of an acryl pressure-sensitive adhesive which can be cured with ultraviolet rays onto a supporting substrate composed of a polyethylene film having a thickness of 60 µm and drying. Thereafter, only the portion where a wafer is pasted was irradiated with ultraviolet rays at 500 mJ/cm² through a mask, and a pressure-sensitive adhesive film **C** was obtained composed of this supporting substrate and the pressure-sensitive adhesive layer in which a portion which is pasted to a wafer was cured with ultraviolet rays. The irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of about 300 000 was obtained by co-polymerizing a monomer mixture composed of 100 parts by weight of butylacrylate and 2 parts by weight of acrylic acid using 200 parts by weight of toluene and 0.1 parts by weight of azoisobutylonitrile in a conventional method.
Next, a solution of the above acryl pressure-sensitive adhesive having a concentration of 30 % by weight was obtained by compounding 100 parts by weight of this acryl polymer, 0.5 parts by weight of a multi-functional epoxy compound as a cross-linking agent, 5 parts by weight of dipentaerythritol monohydroxy pentaacrylate as a photopolymerizable compound, and 1 part by weight of α-hydroxycyclohexylphenylketone as a photopolymerization initiator and uniformly dissolving them into toluene as an organic solvent.

Here, the storage elastic modulus at 23 °C of the pressure-sensitive adhesive film C was measured. As a result, it was 7 x 10⁵ Pa. Here, details of the measurement method will be described later.

Next, the dicing die-bonding film according to the present comparative example was produced using the pressure-sensitive adhesive film C in the same method as in Example 1.

### Comparative Example 4

A pressure-sensitive adhesive layer having a thickness of 30 µm was formed by applying a solution of an acryl pressure-sensitive adhesive which can be cured with ultraviolet rays onto a supporting substrate composed of a polyethylene film having a thickness of 60 µm and drying. Thereafter, only the portion where a wafer is pasted was irradiated with ultraviolet rays at 500 mJ/cm² through a mask, and a pressure-sensitive adhesive film **D** was obtained composed of this supporting substrate and the pressure-sensitive adhesive layer in which a portion which is pasted to a wafer was cured with ultraviolet rays. The irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of 400 000 was obtained by co-polymerizing a monomer mixture composed of 100 parts by weight of methylmethacrylate and 5 parts by weight of acrylic acid using 200 parts by weight of toluene and 0.1 parts by weight of azoisobutylonitrile in a conventional method.
Next, a solution of the above acryl pressure-sensitive adhesive having a concentration of 30% by weight was obtained by compounding 100 parts by weight of this acryl polymer, 3 parts by weight of a multi-functional epoxy compound as a cross-linking agent, 30 parts by weight of dipentaerythritol monohydroxy pentaacrylate as a photopolymerizable compound, and 3 parts by weight of α-hydroxycyclohexylphenylketone as a photopolymerization initiator and uniformly dissolving them into methanol as an organic solvent.

Here, the storage elastic modulus at 23 °C of the pressure-sensitive adhesive film **D** was measured. As a result, it was 8 x 10¹⁰ Pa. Here, details of the measurement method will be described later.

Next, the dicing die-bonding film according to the present comparative example was produced using the pressure-sensitive adhesive film **D** in the same method as in Example 1.

### Example 4

A pressure-sensitive adhesive layer having a thickness of 10 µm was formed by applying a solution of an acryl pressure-sensitive adhesive which can be cured with ultraviolet rays onto a supporting substrate composed of a polyethylene film having a thickness of 60 µm and drying. Thereafter, only the portion where a wafer is attached was irradiated with ultraviolet rays at 500 mJ/cm² through a mask, and a pressure-sensitive adhesive film a was obtained composed of this supporting substrate and the pressure-sensitive adhesive layer in which a portion which is pasted to a wafer was cured with ultraviolet rays. A method of measuring the thickness of the pressure-sensitive adhesive layer and the irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of 800 000 was obtained by co-polymerizing 70 parts by weight of butylacrylate, 30 parts by weight of ethylacrylate, and 5 parts by weight of acrylic acid in ethylacetate in a conventional method.
Next, a solution of the acryl pressure-sensitive adhesive having a concentration of 18 % by weight was obtained by compounding 0.5 parts by weight of a multi-functional epoxy compound as a cross-linking agent, 20 parts by weight of dipentaerythritol monohydroxy pentaacrylate as a photopolymerizable compound, and 1 part by weight of α-hydroxycyclohexylphenylketone as a photopolymerization initiator to 100 parts by weight of this acryl polymer and uniformly dissolving them into toluene as an organic solvent.

Here, the storage elastic modulus at 23 °C of the pressure-sensitive adhesive film a was measured. As a result, it was 8 x 10⁶ Pa. Here, details of the measurement method will be described later.

Next, production of the die bonding adhesive layer was performed. That is, 3 parts by weight of a multi-functional isocyanate cross-linking agent, 23 parts by weight of an epoxy resin (Epicoat 1004, manufactured by Japan Epoxy Resins Co., Ltd.), and 6 parts by weight of a phenol resin (MILEX XLC-LL, manufactured by Mitsui Chemicals, Inc.) based on100 parts by weight of an acrylic acid ester polymer having ethylacrylate-methylmetacrylate as a main component (PARACRON W-197CM, manufactured by Negami Chemical Industrial Co., Ltd.) were dissolved into methylethylketone, and the concentration was adjusted to 20 % by weight.

This solution of the adhesive composition was applied onto a mold-releasing process film composed of a polyethylene terephthalate film having a thickness of 50 µm. Thereafter, it was dried at 120 °C for 3 minutes to form a die bonding adhesive layer a having a thickness of 20 µm. Here, as the mold-releasing process film, those in which a silicone mold-releasing process was performed on a polyethylene terephthalate film were used.

Consequently, the die bonding adhesive layer a was transferred to the pressure-sensitive adhesive layer side on the pressure-sensitive adhesive film a composed of the above acryl pressure-sensitive adhesive to obtain the dicing die-bonding film according to the present example was obtained.

### Example 5

In the present example, the dicing die-bonding film according to the present example was produced in the same method as in Example 4 except that a polymer having butylacrylate as a main component (PARACRON SN-710, manufactured by Negami Chemical Industrial Co., Ltd.) was used in place of the acrylic acid ester polymer having ethylacrylate-methylmethacrylate as a main component and the thickness of the pressure-sensitive adhesive layer was changed to 30 µm.

### Example 6

A pressure-sensitive adhesive layer having a thickness of 70 µm was formed by applying a solution of an acryl pressure-sensitive adhesive which can be cured with ultraviolet rays onto a supporting substrate composed of a polyethylene film having a thickness of 80 µm and drying. Thereafter, only the portion where a wafer is pasted was irradiated with ultraviolet rays at 500 mJ/cm² through a mask, and a pressure-sensitive adhesive film b was obtained composed of this supporting substrate and the pressure-sensitive adhesive layer in which a portion which is pasted to a wafer was cured with ultraviolet rays. The irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of 500 000 was obtained by co-polymerizing a compounded composition composed of 50 parts by weight of ethylacrylate, 50 parts by weight of butylacrylate, and 16 parts by weight of 2-hydroxyethylacrylate in a toluene solution.

Next, a carbon-carbon double bond was introduced into a side chain of the polymer molecule by subjecting 20 parts by weight of 2-methacryloyloxyethylisocyanate to an addition reaction based on 100 parts by weight of this acryl polymer. The length of the side chain at this time was 13 atoms in number of atoms. A solution of the above acryl pressure-sensitive adhesive having a concentration of 27 % by weight was obtained by further compounding 1 part by weight of a multi-functional isocyanate cross-linking agent and 3 parts by weight of an acetophenone photopolymerization initiator based on 100 parts by weight of this polymer and uniformly dissolving them into toluene as an organic solvent.

Here, the storage elastic modulus at 23 °C of the pressure-sensitive adhesive film b was measured. As a result, it was 3 x 10⁵ Pa. Here, details of the measurement method will be described later.

Next, production of the die bonding adhesive layer a was performed in the same method as in Example 4. Consequently, the die bonding adhesive layer a was transferred to the pressure-sensitive adhesive layer side on the pressure-sensitive adhesive film b composed of the above acryl pressure-sensitive adhesive to obtain the dicing die-bonding film according to the present example.

### Comparative Example 5

The dicing die-bonding film according to the present example was produced in the same method as in Example 4 except that the thickness of the pressure-sensitive adhesive layer was made to be 100 µm.

### Comparative Example 6

A pressure-sensitive adhesive layer having a thickness of 30 µm was formed by applying a solution of an acryl pressure-sensitive adhesive which can be cured with ultraviolet rays onto a supporting substrate composed of a polyethylene film having a thickness of 60 µm and drying. Thereafter, only the portion where a wafer is pasted was irradiated with ultraviolet rays at 500 mJ/cm² through a mask, and a pressure-sensitive adhesive film c was obtained composed of this supporting substrate and the pressure-sensitive adhesive layer in which a portion which is pasted to a wafer was cured with ultraviolet rays. The irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of about 300 000 was obtained by co-polymerizing a monomer mixture composed of 100 parts by weight of butylacrylate and 2 parts by weight of acrylic acid using 200 parts by weight of toluene and 0.1 parts by weight of azoisobutylonitrile in a conventional method.
Next, a solution of the above acryl pressure-sensitive adhesive having a concentration of 30 % by weight was obtained by compounding 100 parts by weight of this acryl polymer, 0.5 parts by weight of a multi-functional epoxy compound as a cross-linking agent, 5 parts by weight of dipentaerythritol monohydroxy pentaacrylate as a photopolymerizable compound, and 1 part by weight of α-hydroxycyclohexylphenylketone as a photopolymerization initiator and uniformly dissolving them into toluene as an organic solvent.

Here, the storage elastic modulus at 23 °C of the pressure-sensitive adhesive film c was measured. As a result, it was 3 x 10³ Pa. Here, details of the measurement method will be described later.

Next, the dicing die-bonding film according to the present comparative example was produced using the pressure-sensitive adhesive film c in the same method as in Example 4.

### Comparative Example 7

A pressure-sensitive adhesive layer having a thickness of 30 µm was formed by applying a solution of an acryl pressure-sensitive adhesive which can be cured with ultraviolet rays onto a supporting substrate composed of a polyethylene film having a thickness 60 µm and drying. Thereafter, only the portion where a wafer is pasted was irradiated with ultraviolet rays at 500 mJ/cm² through a mask, and a pressure-sensitive adhesive film d was obtained composed of this supporting substrate and the pressure-sensitive adhesive layer in which a portion which is pasted to a wafer was cured with ultraviolet rays. The irradiation condition of the ultraviolet rays will be described later.

Preparation of the solution of the acryl pressure-sensitive adhesive which can be cured with the ultraviolet rays was performed as follows. That is, an acryl polymer having a weight average molecular weight of about 400 000 was obtained by co-polymerizing a monomer mixture composed of 100 parts by weight of methylmethacrylate and 5 parts by weight of acrylic acid using 200 parts by weight of toluene and 0.1 parts by weight of azoisobutylonitrile in a conventional method.
Next, a solution of the above acryl pressure-sensitive adhesive having a concentration of 26 % by weight was obtained by compounding 100 parts by weight of this acryl polymer, 3 parts by weight of a multi-functional epoxy compound as a cross-linking agent, 30 parts by weight of dipentaerythritol monohydroxy pentaacrylate as a photopolymerizable compound, and 3 parts by weight of α-hydroxycyclohexylphenylketone as a photopolymerization initiator and uniformly dissolving them into methanol as an organic solvent.

Here, the storage elastic modulus at 23 °C of the pressure-sensitive adhesive film d was measured. As a result, it was 5 x 10¹⁰ Pa. Here, details of the measurement method will be described later.

Next, the dicing die-bonding film according to the present comparative example was produced using the pressure-sensitive adhesive film d in the same method as in Example 4.

### Dicing and Pick-Up

The dicing die-bonding was actually performed with the following guidlines using each dicing die-bonding film of Examples 1 to 6 and Comparative Examples 1 to 7, and performance of each dicing die-bonding film was evaluated.

A backside polishing process was performed on a semiconductor wafer (diameter of 8 inch, thickness of 0.6 mm) in which a circuit pattern was formed, and a mirror wafer having a thickness of 0.15 mm was used as a workpiece. DFG-840 (trade name) manufactured by DISCO Corporation was used as a grinding device. This mirror wafer was pasted onto each dicing die-bonding film by adhering with pressure with a roll at 40 °C, and dicing was further performed. A wafer pasting apparatus (DR-8500) manufactured by Nitto Seiki Co., Ltd. was used for pasting.
Further, the dicing was performed in full cut so that the size of a chip becomes 5 mm square. Presence or absence of yarn-shape scraps was investigated for the semiconductor wafer and the dicing die-bonding film after cutting. Details of the observation method of the yarn-shaped scraps and the dicing condition will be described later.

Next, an expanding step in which the space between chips was made to be prescribed dimension was performed for each dicing die-bonding film of Examples 1 to 3 and Comparative Examples 1 to 4 by stretching the films. Furthermore, a silicon chip was picked-up with a pushing-up method with a needle from the supporting substrate side of each dicing die-bonding film, and evaluations of the chip fly and pick-up properties were performed. Further, presence or absence of chipping was investigated for the chip which was picked-up. The measurement condition will be described later.

### Measurement Method of the Thickness of the Pressure-sensitive Adhesive Layer

The measurement of the thickness of the pressure-sensitive adhesive layer was performed with a 1/1000 dial gauge.

### Ultraviolet Ray Irradiation Condition

Ultraviolet ray (UV) irradiation apparatus: NEL M-110 (trade name, manufactured by Nitto Seiki Co., Ltd.)
Ultraviolet ray irradiation integrated light quantity: 500 mJ/cm²

### Measurement Method of the Storage Elastic Modulus

The storage elastic modulus was measured using a viscoelastic spectrometer manufactured by TA Instruments, Japan (trade name: RSA-II). The measurement value was at 23 °C in a range of -50 °C to 200 °C with a measurement condition of frequency of 1 Hz, sample thickness of 2 mm, load for adhering with pressure of 100 g, and speed of temperature increase of 5 °C/min.

**Dicing Condition**

| | |
|---|---|
| Dicing apparatus: | DFD-651 (trade name, manufactured by |
| | DISCO Corporation) |
| Dicing speed: | 80 mm/sec. |
| Dicing blade: | 2050HECC (trade name, manufactured by |
| | DISCO Corporation) |
| Rotation speed: | 40,000 rpm |
| Cut depth to the dicing die-bonding film: 15 µm (see Fig. 6) | |
| Cutting manner: | full cut and A mode |
| Chip size: | 5 mm square |

### Observation Method of the Yarn-Shaped Scraps

The left and right three lines (total of 7 lines) including a center line of a semiconductor wafer which was cut were observed with an optical microscope (magnification 50x), and the number of yarn-shaped scraps having a length of 10 µm or more was counted (see Fig. 4). The observation of the yarn-shaped scraps was performed on the surface and the side face of the semiconductor chip and the surface in the vicinity of the line cut of the dicing die-bonding film.

**Expanding Condition**

| | |
|---|---|
| Dicing ring: | 2-8-1 (trade name, manufactured by DISCO |
| | Corporation, inner diameter of 19.5 cm) |
| Reduction amount: | 5 mm |
| Die bonder: | SPA-300 (trade name, manufactured by |
| | Shinkawa Ltd.) |

### Chipping Evaluation Method

After dicing, arbitrary 50 semiconductor chips (bodies to be cut) were picked-up (peeled off), and chipping on the side face of the semiconductor chip was observed. A break of the chip having a triangle shape was observed as a chipping, and chippings having a size of 20 µm or more were counted.

### Pick-Up Properties Evaluation

Presence or absence of attachment of the pressure-sensitive adhesive onto the backside of the semiconductor chip was observed when the semiconductor chip having 5 mm x 5 mm square which was diced was picked-up. Here, when picking-up, the pressure-sensitive adhesive layer which was left under a high pressure mercury lamp having 80 W/cm² for 10 seconds was cured with radiation, and then the pick-up was performed. As a result, evaluation was performed by marking in the case where the pick-up of the chip was performed without cracks and chippings as "O" and in the case where cracks, chippings, or pick-up mistakes was occurred as "X".

### Results

As found in Tables 1 and 2 described below, the yarn-shaped scraps were not observed at all in Examples 1 to 6. However, many of the yarn-shaped scraps were observed in various places in Comparative Example 2.

Some chipping was generated in Examples 3 and 4, however, they were in a state where they were capable of using from the viewpoint of performance of the die. Examples 1, 2, 4, and 5 were good without generating chipping at all. On the other hand, the generation of chipping was observed in Comparative Examples 1, 3, 4, 5, and 6, and they were in a state where they were incapable of using from the viewpoint of performance of the die.
Further, chip fly was not generated at all in each Example, and it was confirmed that it has an adhesive strength which is sufficient to fix a semiconductor chip. On the other hand, a large occurrence of chip fly was observed in Comparative Example 4, and it was confirmed that the adhesive strength of the pressure-sensitive adhesive layer was insufficient. Further, since the dicing ring could not be pasted in the dicing die-bonding film in Comparative Example 7, dicing itself could not be performed.

As is obvious from these test results, when the pressure-sensitive adhesive layer is thin, it was found that the yarn-shaped scraps are easily generated by the dicing blade cutting the supporting substrate. On the other hand, when it is too thick, it was confirmed that chipping is generated and the grade of the semiconductor chip remarkably decreases.

**Table 1**

| | Example 1 | Example 2 | Example 3 | Comparative Example 1 | Comparative Example 2 | Comparative Example 3 | Comparative Example 4 |
|---|---|---|---|---|---|---|---|
| Thickness of Pressure-sensitive Adhesive Layer (µm) | 20 | 30 | 70 | 100 | 3 | 30 | 30 |
| Storage Elastic Modulus (Pa) | 3 × 10⁸ | 3 × 10⁸ | 4 × 10⁷ | 3 × 10⁸ | 3 × 10⁸ | 7 × 10⁵ | 8 × 10¹⁰ |
| Thickness of Die Bonding Adhesive Layer (µm) | 20 | 20 | 10 | 20 | 20 | 20 | 20 |
| Number of Yarn-Shaped Scraps on Chip Surface (scraps) | 0 | 0 | 0 | 0 | 30 | 0 | 0 |
| Number of Yarn-Shaped Scraps on Chip Side Face (scraps) | 0 | 0 | 0 | 0 | 17 | 0 | 0 |
| Number of Yarn-Shaped Scraps on Surface of Dicing die-bonding Film (scraps) | 0 | 0 | 0 | 0 | 120 | 0 | 0 |
| Number of Large Chip Breaks (large chippings /50 chippings) | 0 | 0 | 2 | 35 | 0 | 48 | 26 |
| 10. Generation of Chip Fly (chip flys/50 chips) | 0 | 0 | 0 | 0 | 0 | 0 | 36 |
| Pick-Up Properties (-) | ○ | ○ | ○ | ○ | ○ | × | ○ |

**Table 2**

| | Example 4 | Example 5 | Example 6 | Comparative Ex ample 5 | Comparative Example 6 | Comparative Example 7 |
|---|---|---|---|---|---|---|
| Thickness of Pressure-sensitive Adhesive Layer (µm) | 10 | 30 | 70 | 100 | 30 | 30 |
| Storage Elastic Modulus (Pa) | 8 × 10⁶ | 8 × 10⁶ | 3 × 10⁵ | 3 × 10⁵ | 3 × 10³ | 5 × 10¹⁰ |
| Thickness of Die Bonding Adhesive Layer (µm) | 20 | 20 | 10 | 20 | 20 | 20 |
| Number of Yarn-Shaped Scraps on Chip Surface (scraps) | 0 | 0 | 0 | 0 | 0 | Incapable of dicing |
| Number of Large Chip Breaks (large chippings/50 chippings) | 0 | 0 | 2 | 35 | 48 | |

## Claims

1. A dicing die-bonding film comprising a pressure-sensitive adhesive layer and a die bonding adhesive layer being sequentially laminated on a supporting substrate,
wherein the pressure-sensitive adhesive layer has a thickness of 10 µm to 80 µm, and has a storage elastic modulus at 23 °C of 1 x 10⁴ Pa to 1 x 10¹⁰ Pa.

2. The dicing die-bonding film according to claim 1,
wherein the pressure-sensitive adhesive layer is a radiation curing type pressure-sensitive adhesive layer.

3. The dicing die-bonding film according to claim 1,
wherein the numerical value range of the storage elastic modulus in the pressure-sensitive adhesive layer is satisfied at least by a portion corresponding to a workpiece attachment portion of the die bonding adhesive layer.

4. The dicing die-bonding film according to claim 3,
wherein the peeling properties at the interface between the pressure-sensitive adhesive layer and the die bonding adhesive layer, which is the interface corresponding to the workpiece attachment portion are greater than the peeling properties at the interface corresponding to a portion or the entirety other than the workpiece attachment portion.

5. The dicing die-bonding film according to claim 3,
wherein the adhesive strength of the pressure-sensitive adhesive layer to the die bonding adhesive layer, which is the adhesive strength of the portion corresponding to the workpiece attachment portion is smaller than the adhesive strength of the portion corresponding to a portion or the entirety other than the workpiece attachment portion.

6. The dicing die-bonding film according to claim 3 or 4,
wherein the adhesive strength of the die bonding adhesive layer to the workpiece at the workpiece attachment portion is greater than the adhesive strength to the pressure-sensitive adhesive layer at the portion corresponding to the workpiece attachment portion.

7. The dicing die-bonding film according to any one of claims 2 to 5,
wherein a part of the portion other than the workpiece attachment portion is a dicing ring attachment portion.

8. The dicing die-bonding film according to claim 6,
wherein the adhesive strength of the die bonding adhesive layer to the dicing ring at the dicing ring attachment portion is smaller than the adhesive strength to the pressure-sensitive adhesive layer at the portion corresponding to the dicing ring attachment portion.

9. The dicing die bong film according to claim 1 or 2,
wherein the die bonding adhesive layer is provided on a part of the pressure-sensitive adhesive layer as a workpiece attachment portion, and wherein the adhesive strength of a part corresponding to the workpiece attachment portion of the pressure-sensitive adhesive layer is smaller than the adhesive strength of the portion other than the workpiece attachment portion.

10. The dicing die-bonding film according to claim 9,
wherein the adhesive strength of the die bonding adhesive layer to the workpiece at the workpiece attachment portion is greater than the adhesive strength to the pressure-sensitive adhesive layer at the portion corresponding to the workpiece attachment portion.

11. The dicing die-bonding film according to any one of claims 2 to 9,
wherein the pressure-sensitive adhesive layer is formed by a radiation curing type pressure-sensitive adhesive, and wherein the portion corresponding to the workpiece attachment portion is in a state of being cured by a radiation irradiation.

12. A method of fixing a chip-shaped workpiece using the dicing die-bonding film according to any one of claims 1 to 11,
comprising the following steps:
- compressing a workpiece onto the workpiece attachment portion of the die bonding adhesive layer;
- dicing the workpiece together with the die bonding adhesive layer into a chip shape and stopping dicing at the pressure-sensitive adhesive layer;
- peeling the chip-shaped workpiece together with the workpiece attachment portion of the die bonding adhesive layer from the pressure-sensitive adhesive layer; and
- adhering and fixing the chip-shaped workpiece onto a semiconductor element interposing the workpiece attachment portion of the die bonding adhesive layer therebetween.

13. A semiconductor device, wherein the chip-shaped workpiece is adhered and fixed onto a semiconductor element interposing the workpiece attachment portion of the die bonding adhesive layer therebetween with the method of fixing the chip-shaped workpiece according to claim 12.

14. A method for manufacturing a semiconductor device using the dicing die-bonding film according to any one of claims 1 to 11, comprising the following steps:
- compressing a workpiece onto the workpiece attachment portion of the die bonding adhesive layer;
- dicing the workpiece together with the die bonding adhesive layer into a chip shape and stopping dicing at the pressure-sensitive adhesive layer;
- peeling the chip-shaped workpiece together with an adhesive in the die bonding adhesive layer from the pressure-sensitive adhesive layer; and
- adhering and fixing the chip-shaped workpiece onto a semiconductor element interposing the adhesive therebetween.

15. A semiconductor device, wherein the chip-shaped workpiece is adhered and fixed onto a semiconductor element interposing the adhesive in the die bonding adhesive layer therebetween with the method of manufacturing the semiconductor device according to claim 14.
